# EUROPÄISCHE PATENTSCHRIFT

(11) **EP 1 807 371 B1**
(45) Veröffentlichungstag und Bekanntmachung des Hinweises auf die Patenterteilung: **20.06.2012**
(21) Anmeldenummer: 05802295.5
(22) Anmeldetag: 03.11.2005
(51) Int. Cl.: C03C 17/245, C03C 17/34, C03C 17/42, C23C 16/453

(54) **VERFAHREN ZUR HERSTELLUNG EINES GLASKERAMIK-GEGENSTANDES MIT BARRIERBESCHICHTUNG**
METHOD FOR PRODUCING A GLASS-CERAMIC ARTICLE WITH BARRIER LAYER
METHODE DE FABRICATION D'UN ARTICLE DE VITROCERAMIQUE REVETU D'UNE COUCHE BARRIERE

(30) Priorität: 03.11.2004 DE 102004053706
(43) Veröffentlichungstag der Anmeldung: 18.07.2007
(60) Teilanmeldung: 10010428.0
(73) Patentinhaber: Schott AG, 55122 Mainz (DE)
(72) Erfinder: HENZE, Inka, 55268 Nieder-Olm (DE); GUDGEL, Todd, J., 1605 Evanston, Illinois 60201 (US); WEBER, Gerhard, 55234 Bechenheim (DE); LUTHER, Veit, 65795 Hattersheim (DE); SCHULTHEIS, Bernd, 55270 Schwabenheim (DE); GABEL, Falk, 65388 Schlangenbad (DE)
(74) Vertreter: Herden, Andreas F.
(86) Internationale Anmeldenummer: PCT/EP2005/011752
(87) Internationale Veröffentlichungsnummer: WO 2006/048276

(56) Entgegenhaltungen:
- EP-A- 0 151 233
- EP-A- 0 594 171
- EP-A- 0 842 908
- EP-A- 1 148 036
- WO-A-01/02622
- DE-A- 10 206 330
- DE-A- 19 858 933
- US-A- 3 058 866
- US-A1- 2002 058 143

## Beschreibung

Die Erfindung betrifft allgemein die Herstellung von Beschichtungen, insbesondere betrifft die Erfindung die Herstellung eines Gegenstandes mit Barriere- oder Sperrschich.

Barriere- oder Sperrbeschichtungen von Gegenständen werden allgemein zur Versiegelung von Oberflächen, insbesondere zur Verhinderung oder Verlangsamung des Hindurchtretens von Atomen und Molekülen aus und in die Umgebung der Oberfläche eingesetzt. Entsprechend vielfältig sind die Anwendungen für derartige Beschichtungen. So werden Barriereschichten zum Beispiel bei Lebensmittelverpackungen eingesetzt, um eine möglichst hermetische Versiegelung der verpackten Nahrungsmittel und eine Verlängerung der Haltbarkeit zu erreichen.

Zur Herstellung dünner Sperrschichten kommen vielfach Vakuum-oder Niederdruck-Abscheideverfahren, wie Plasma-Deposition, Aufdampfen oder Sputterbeschichtung zum Einsatz. Diese Verfahren sind jedoch aufgrund der notwendigen Evakuierung kostenintensiv. Außerdem sind diese Verfahren auch nicht für jedes Substrat geeignet. Unter anderem ergeben sich Schwierigkeiten bei großformatigen Substraten, für die entsprechend große Vakuumkammern bereitgestellt werden müssten. Auch können Substrate, die im Vakuum stark ausgasen oder aufgrund von eingeschlossenen Gasmengen der mechanischen Belastung bei der Evakuierung nicht gewachsen sind, im allgemeinen nicht mit diesen Verfahren beschichtet werden. Andererseits weisen die mit diesen Verfahren herstellbaren Beschichtungen auch bei sehr geringen Schichtdicken im Nanometer- oder Mikrometer-Bereich bereits sehr hohe Barrierewirkungen auf.

Aus der US 5,165,972 ist eine Barrierebeschichtung auf Glas bekannt, mit welchen die Migration von Alkali-Ionen von der Glasoberfläche verhindert werden soll. Die Beschichtung wird mittels Pyrolyse eines Silan-Gases auf der auf mehr als 600 °C erhitzten Glasoberfläche in Verbindung mit einer gasförmigen Elektronen-Donator-Verbindung erzeugt, wobei Sauerstoff aus der Glasoberfläche an der Bildung der Schicht beteiligt ist. Dieses Verfahren erfordert allerdings sehr heiße
Substratoberflächen und ist daher ebenfalls für eine Vielzahl von Substraten, die nicht hinreichend temperaturstabil sind, nicht geeignet.

Es besteht daher Bedarf, Barrierebeschichtungen mit zumindest vergleichbaren Eigenschaften auch ohne den Einsatz von Vakuumbeschichtungsanlagen und ohne die sich dadurch oder bei der Pyrolyse auf heißen Oberflächen ergebenden Einschränkungen hinsichtlich der Wahl der Substratmaterialien und Substratabmessungen verwenden und herstellen zu können.

Die EP 1 148 036 A1 offenbart offenbart die flammpyrolytische Modifizierung der Oberfläche eines kompakten Substrats, die eine Verbesserung der Hafteigenschaften zwischen diesem Substrat und einer weiteren auf die modifizierte Oberfläche aufgebrachten Schicht, beispielsweise einer Farbschicht, bezweckt. Auch hier wird das Substrat vorteilhafter Weise auf 50 bis 100 °C aufgeheizt.

Die Offenlegungsschriften DE 198 58 933 A1 und EP 0 842 908 A1 offenbaren Wasser- und Schmutz-abweisende Eigenschaften von flammpyrolytisch abgeschiedenen SiO₂-haltigen Schichten, die auf Gläser, vorzugsweise auf Fenster- oder Fahrzeugscheiben, aufgebracht werden.

In der DE 102 06 330 A1 werden anorganische Funktionsschichten, insbesondere keramische Leuchtstoffschichten beschrieben, die mithilfe der Flammpyrolyse abgeschieden werden. Der Vorteil der offenbarten Schichten besteht darin, dass sie eine erhöhte mechanische Festigkeit gegenüber herkömmlichen Pulverschichten aufweisen. Auch sind mit diesem Verfahren neuartige Materialzusammensetzungen darstellbar.
Aus der DE 100 62 187 A1 ist ein Verfahren zum Keramisieren des Ausgangsglases einer Glaskeramik bekannt, bei welchem das Grünglas auf einer Levitationsunterlage durch Zufuhr von Levitationsgas in einem Schwebezustand versetzt und das Grünglas im Schwebezustand durch eine IR-Strahlung so lange erwärmt wird, bis die gewünschte Keramisierung eingetreten ist.

Mit dem Verfahren werden Oberflächendefekte auf der Glaskeramik vermieden. Allerdings wird auf die üblicherweise verwendete Keramisierung auf einer Unterlage verzichtet, so dass eine spezielle Keramisierungsanlage zur Durchführung des Verfahrens notwendig ist.

Die Erfindung wird durch die Merkmale des Anspruchs 1 definiert. Vorteilhafte Ausgestaltungen und Weiterbildungen sind Gegenstand der Unteransprüche.

Im Unterschied zu dem aus der US 5, 165, 972 bekannten Verfahren findet eine Hydrolyse der metallhaltigen Verbindung bereits in der Flamme statt. Die Flamme kann das Substrat dabei sehr schnell überstreichen, so daß sich das Substrat nur unwesentlich erwärmt. Aufgrund der Hydrolyse in der Flamme wird eine Veränderung der Stöchiometrie der Substratoberfläche durch Einbindung von Sauerstoff, wie sie sich aus dem aus der US 5,165,972 bekannten Verfahren unter Sauerstoffausschluß ergibt, außerdem weitgehend vermieden.

Mittels der Erfindung können Barrierebeschichtungen hergestellt werden, welche in ihren Barriereeigenschaften zumindest vergleichbar zu aufgesputterten oder mittels Plasmabeschichtung abgeschiedenen Barriereschichten sind. Im Unterschied zu diesen bekannten Verfahren zur Herstellung von Barriereschichten ist erfindungsgemäß aber keine Evakuierung der Umgebung des zu beschichtenden Substrats nötig. Die für Vakuumbeschichtungsverfahren, wie Sputtern, Aufdampfen oder plasmainduzierte Dampfphasenabscheidung notwendige Evakuierung ist aber ein wesentlicher Kostenfaktor, der bei der erfindungsgemäßen Beschichtung entfallen kann. Auch können erfindungsgemäß beispielsweise sehr großflächige Substrate problemlos mit einer Barrierebeschichtung versehen werden, die ansonsten in einer entsprechend großvolumigen und damit teuren Vakuumbeschichtungsanlage aufgebracht werden müßten.

Von den mit Vakuumabscheideverfahren abgeschiedenen Schichten unterscheiden sich die erfindungsgemäßen flammpyrolytisch aufgebrachten, beziehungsweise abgeschiedenen Schichten im allgemeinen bereits dadurch, daß die flammpyrolytischen Schichten OH-Gruppen aufweisen. Insbesondere befinden sich solche Hydroxylgruppen auch an der Oberfläche der Schicht. Damit wird neben einer für die Barriereeigenschaften dichten Struktur außerdem noch eine Oberfläche mit einer hohen Oberflächenenergie und funktionellen Gruppen geschaffen, die eine gute Anbindung weiterer Moleküle erlauben. Dementsprechend eignen sich die erfindungsgemäßen Schichten unter anderem gleichzeitig noch besonders gut für eine Weiterverarbeitung, wie etwa für das Aufbringen weiterer Beschichtungen, die auf den erfindungsgemäßen Schichten besonders gut haften.

Durch die hohe Oberflächenenergie wird außerdem auch eine wirkungsvolle Antibeschlag-Wirkung erzeugt. Dies ist genauer in der am gleichen Tag wie die vorliegende Erfindung eingereichte deutsche Patentanmeldung der Anmelderin mit dem Titel "Verfahren zur Herstellung eines Erzeugnisses mit Antibeschlag-Beschichtung, sowie verfahrensqemäß herstellbares Erzeugnis" beschrieben, deren Ausführungsformen vollumfänglich auch zum Gegenstand der vorliegend beschriebenen Erfindung gemacht werden.

Gemäß einer bevorzugten Ausführungsform der Erfindung wird eine silikathaltige flammpyrolytisch aufgebrachte Schicht hergestellt. Eine derartige Schicht kann hergestellt werden, indem eine silikathaltige Schicht durch Hydrolyse einer Siliziumverbindung in der Flamme abgeschieden wird. Geeignete Siliziumverbindungen dazu sind unter anderem Hexamethyldisiloxan (HMDSO), Hexamethyldisilazan (HMDSN), Tetramethoxysilan, Tetraethoxysilan.

Zusätzlich oder alternativ können der flammpyrolytischen, beziehungsweise flammpyrolytisch aufgebrachten Schicht vorteilhafte funktionelle Eigenschaften verliehen werden, wenn die flammpyxolytische Schicht ein Oxid zumindest eines der Metalle Titan, Aluminium, Zirkonium, Zinn, Indium enthält, indem bei der Abscheidung der Schicht in der Flamme eine Verbindung eines der Metalle Titan, Aluminium, Zirkonium, Zinn, Indium hydrolysiert wird. Diese Metalloxide können, auch in Verbindung mit Siliziumoxid, beziehungsweise Silikat in der flammpyrolytischen Schicht, auch gemischt vorliegen. Aus Mischungen von derartigen Metalloxiden, beziehungsweise, können beispielsweise sehr harte und/oder feuchtebeständige und/oder leitfähige Schichten erzeugt werden. Als Mischung wird im Sinne der Erfindung auch eine Dotierung verstanden. So kann unter anderem eine silikathaltige flammpyrolytische Schicht mit einem anderen Metalloxid, beispielsweise einem oder mehreren Oxiden der vorgenannten Metalle, dotiert werden, um zusätzliche funktionelle Eigenschaften zu erhalten und/oder die Barriereeigenschaften der flammpyrolytischen Schicht zu verbessern. So eignet sich beispielsweise Zinnoxid als wärmereflektierende Schicht.

Eine erfindungsgemäße flammpyrolytische Schicht kann auch ein mit anderen Materialien gemischtes oder dotiertes Metalloxid enthalten. Ein vorteilhaftes Beispiel für eine flammpyrolytisch abgeschiedene Schicht mit zusätzlichen funktionellen Eigenschaften ist eine Zinnoxid-haltige flammpyrolytische Schicht, welche mit Fluor und/oder Indium dotiert ist. Eine derartige Schicht eignet sich beispielsweise zu ihren wärmereflektierenden Eigenschaften auch zur Reduzierung der statischen Aufladung von Oberflächen oder als leitfähige transparente Schicht.

Verschiedene flammpyrolytisch abgeschiedene Oxide können nicht nur in einer Schicht miteinander gemischt werden. Es ist gemäß einer Weiterbildung der Erfindung auch daran gedacht, eine mehrlagige flammpyrolytische Schicht abzuscheiden. Durch einen mehrschichtigen oder mehrlagigen Aufbau können unter anderem optische Effekte, wie beispielsweise Ver- oder Entspiegelungen und/oder Farbortverschiebungen erreich werden. Selbstverständlich kann auch das Verfahren der Abscheidung mittels der flammpyrolytischen Beschichtung auch mit anderen Beschichtungsverfahren kombiniert werden, um eine mehrlagige Funktionalschicht zu erhalten.

Sogar eine C-radientenschicht mit kontinuierlich variierender Zusammensetzung in Richtung senkrecht zur Oberfläche kann erfindungsgemäß flammpyrolytisch abgeschieden werden. Flammpyrolytische Schichten mit einer Mischung verschiedener Oxide können beispielsweise durch Überstreichen des Substrats mit einer Flamme und Abscheiden einer metalloxidhaltigen Schicht mittels Hydrolyse mehrerer metallhaltiger Verbindungen in der Flamme abgeschieden werden. Auch kann die Oberfläche sequentiell mit Flammen überstrichen werden, denen jeweils unterschiedliche metallhaltige Verbindungen zugeführt werden, um eine flammpyrolytische Beschichtung abzuscheiden, die verschiedene Oxide enthält. Letzteres Verfahren eignet sich insbesondere auch zur Abscheidung mehrlagiger flammpyrolytischer Schichten. Ein sequentielles Überstreichen der Oberfläche kann beispielsweise mittels mehrerer hintereinander angeordneter Brenner erreicht werden, an welchen das Substrat vorbeibewegt wird, und/oder mit welchen das Substrat überstrichen wird.

Eine Kombination von Eigenschaften lässt sich durch eine Mischung von Precursor-Gasen über eine Flamme oder durch mehrere Flammen hintereinander angeordnet mit unterschiedlichen geeigneten Metalloxid-haltigen Verbindungen erreichen. Aus Mischungen von Metalloxiden, z.B. mit Metallen wie Si, Ti, Al, Zr, Sn, In, Sb können beispielsweise sehr harte und/oder feuchtebeständige und/oder leitfähige Schichten erzeugt werden.

Bevorzugt wird weiterhin ein Methan, Propan- oder Butan enthaltendes Brenngas zur Erzeugung der Flamme verwendet. Diese Gase sind als Brenngas vergleichsweise kostengünstig und erzeugen ausreichende Flammentemperaturen. Die Verbrennung kann an Luft oder mittels separat zugeführtem Sauerstoff erfolgen.

Um eine möglichst vollständige Hydrolyse der metallhaltigen Verbindung in der Flamme zu erreichen, hat es sich weiterhin als vorteilhaft erwiesen, wenn eine Flamme mit einem oxidierenden und einem reduzierenden Teil erzeugt und das Substrat nur mit dem oxidierenden Teil überstrichen wird. Eine weitere Maßnahme ist, ein eine reduzierende Komponente, vorzugsweise Wasserstoff oder Kohlenmonoxid enthaltendes Brenngas zur Erzeugung der Flamme zu verwenden.

Es hat sich überraschend gezeigt, daß bereits sehr dünne flammpyrolytische Schichten gute Barriereeigenschaften aufweisen. So weisen bereits Schichtdicken einer erfindungsgemäß flammpyrolytisch abgeschiedenen Barrierebeschichtung von 1 bis 100 Nanometern, bevorzugt 4 bis 40 Nanometern, oder sogar von höchstens 20 Nanometern sehr gute Barrierewirkungen auf.

Weiterhin zeigt sich, daß mit der flammpyrolytischen Abscheidung eine körnige Oberflächenstruktur mit Körnern auf der Oberfläche der abgeschiedenen Schicht mit einem in Aufsicht betrachteten Durchmesser bis höchstens 80 Manometer, vorzugsweise bis höchstens 60 Nanometer erzeugt werden kann. Dabei sind die Körner auf der Oberfläche einer dichten flammpyrolytischen Schicht angeordnet. Bei einer solchen Schicht wird als Schichtdicke die Schichtdicke der dichten Schicht ohne den darauf angeordneten Körnern verstanden.

Eine derartige Schichtstruktur wurde insbesondere bei einer Siliziumoxid-haltigen Schicht gefunden. Es wird dabei nicht ausgeschlossen, daß sich auch einzelne Körner mit noch größeren Durchmessern auf der Oberfläche finden. Beispielsweise kann es zu einer Agglomeration mehrerer Körner kommen, welche im Mikroskop dann unter Umständen wie ein einzelnes Korn erscheinen können. Jedenfalls weisen bei erfindungsgemäßen Schichten gemäß dieser Ausführungsform der Erfindung mehr als 90% der bei 200000-facher Vergrößerung im Rasterelektronenmikroskop erkennbaren Körner einem Durchmesser bis höchstens 80 Nanometer, vorzugsweise bis höchstens 60 Nanometer auf. Im allgemeinen weisen die Körner überwiegend Durchmesser bis 40 Nanometer auf. Auch können sich größere Körner mit größerem Durchmesser erkennbar aus solchen kleineren, agglomerierten Körnern zusammensetzen. Diese Schichten ermöglichen unter anderem eine besonders gut haftende Beschichtung mit weiteren Schichten, da durch die körnige Struktur einer derart abgeschiedenen Schicht eine sehr große Oberfläche erreicht werden kann. Außerdem kann die Empfindlichkeit gegen ein Verkratzen herabgesetzt werden.

Gemäß einer Ausführungsform der Erfindung ist vorgesehen, ein Glas- oder Glaskeramiksubstrat mit der flammpyrolytischen Beschichtung zu versehen. Obwohl Glas oder Glaskeramik selbst im allgemeinen bereits gute Barriereeigenschaften aufweist, kann eine erfindungsgemäße zusätzliche Barrierebeschichtung überraschend dennoch die Produkteigenschaften verbessern. Als Barrierebeschichtung auf Glas- oder Glaskeramik ist es insbesondere möglich, die Diffusion von Ionen oder Molekülen aus oder in das Substrat zu verhindern. Beispielsweise kann es beim Tempern oder allgemein einer Erhitzung des Substrats zu einer unerwünschten Diffusion von Substratkomponenten aus dem Substrat oder auch von Komponenten weiterer darauf aufgebrachter Beschichtungen kommen. So kann die erfindungsgemäße Barrierebeschichtung dazu dienen, beim Einbrennen von Dekorfarbe auf dem Substrat die Diffusion von Bestandteilen der Dekorfarbe in das Substrat und umgekehrt von Bestandteilen aus dem Glas oder der Glaskeramik zu verhindern. Es hat sich in diesem Zusammenhang überraschend gezeigt, daß eine erfindungsgemäße flammpyrolytische Beschichtung in der Lage ist, eine unerwünschte Hof- oder Saumbildung an den Rändern eines auf dem erfindungsgemäß beschichteten Substrat aufgebrachten und eingebrannten Dekors zu verhindern. Das Verfahren gemäß dieser Ausführungsform und damit herstellbare Erzeugnisse werden außerdem in der am gleichen Tag wie die vorliegende Anmeldung eingereichte deutsche Patentanmeldung der Anmelderin mit dem Titel "Glaskeramik-Artikel mit Diffusionsbarriere und Verfahren zur Herstellung eines Glaskeramik-Artikels mit Diffusionsbarriere" beschrieben, Beim Dekoreinbrand konnte eine Hofbildung um das Dekor sogar noch mit einer Schichtdicke der flammpyrolytischen Schicht von nur etwa 10 Nanometern vermieden werden.

Eine weitere Anwendung ist der Korrosionsschutz von Glaskeramik-Artikeln gegenüber aggressiven Gasen und/oder Verbrennungsprodukten. Die Erfindung eignet sich dementsprechend hervorragend auch für gasbeheizte Glaskeramik-Kochfelder, die insbesondere einem direkten Kontakt mit schwefelhaltigen Brenngasen ausgesetzt sind.

Eine besonders vorteilhafte Anwendung ist auch die Beschichtung von Feuerschutzgläsern aus Glaskeramik, Derartige Sichtscheiben werden beispielsweise als Kamin-Brenner- oder Ofensichtscheiben eingesetzt. Glaskeramik kann aber durch die bei der Verbrennung von Holz oder fossilen Brennstoffen, wie Erdgas oder Heizöl freigesetzten Schwefeloxide korridiert werden. Die erfindungsgemäße flammpyrolytische Beschichtung kann hier die Korrosion der Glaskeramik durch Schwefeloxide verhindern oder zumindest verlangsamen.

Die erfindungsgemäße flammpyrolytische Schicht dient bei der Herstellung von Glaskeramik als Gleitschicht zur Vermeidung eines Anklebens eines Ausgangsglases auf einer Keramisierungsunterlage bei der Keramisierung oder zur Vermeidung von Kratzern und Beschädigungen bei der Behandlung des Glassubstrats vor der Keramisierung dienen. Dazu ist vorgesehen, daß die metalloxidhaltige Schicht vor dem Keramisieren auf zumindest eine Seite eines Ausgangsglassubstrats aufgebracht, das Ausgangsglassubstrat mit der beschichteten Seite auf eine Keramisierungsunterlage aufgelegt und dann keramisiert wird. Da das Ausgangsglas bei den beim Keramisieren eingesetzten Temperaturen sehr weich wird, kann es zum Ankleben an die Keramisierungsunterlage kommen. Da das Ausgangsglas im Verlauf der Keramisierung außerdem schrumpft, entstehen dann Beschädigungen bei einem durch den Schrumpfprozess ausgelösten Ablösen von der Unterlage. Diese Beschädigungen führen zu einer verminderten Festigkeit der Glaskeramik. Um tiefergehende Beschädigungen und ein großflächiges Ankleben zu vermeiden, wird daher im allgemeinen ein Ausgangsglas mit einer genoppten Seite zur Keramisierung verwendet, welche dann auf die Keramisierungsunterlage aufgelegt wird. Mit einer erfindungsgemäßen flammpyrolytischen Beschichtung, die als Gleitschicht wirkt, ist es aber auch möglich, beidseitig glatte Ausgangsglassubstrate zu verwenden und dementsprechend auch eine beidseitig glatte Glaskeramikplatte zu erhalten.

Allgemein bewirkt eine derartige flammpyrolytische Sperr- oder Barriereschicht auch eine Versiegelung einer Substrat- oder Schichtoberfläche gegen Wechselwirkung mit Verdampfungskomponenten und/oder Partikel aus einer "Temperumgebung", also bei einem Einsatz des Gegenstands bei hohen Temperaturen. Derartigen Bedingungen werden insbesondere auch Glaskeramik-Gegenstände, wie etwa Kochfelder, Backofenscheiben, Kamin- Ofen- und Brennersichtscheiben ausgesetzt.

Eine Weiterbildung der Erfindung sieht vor, daß dem Brenngas eine metallorganische Verbindung zugesetzt wird, welches durch Hydrolyse ein leitendes oder halbleitendes Oxid ergibt. Damit kann eine flammpyrolytische Schicht erzeugt werden, welche ein leitendes oder halbleitendes Oxid enthält, Derartige Schichten, beispielsweise in Form einer Silikat-, beziehungsweise Siliziumoxidschicht, welche ein halbleitendes oder leitendes Oxid enthält, können zusätzlich zu einer Barrierewirkung auch zur Vermeidung statischer Aufladungen dienen. Beispielsweise kann eine flammpyrolytische Schicht abgeschieden werden, die Zinnoxid enthält. Dazu kann dem Brenngas entsprechend eine zinnhaltige Verbindung, beispielsweise Zinnchlorid oder eine Zinn enthaltende organische Substanz zugesetzt werden.

Die Eigenschaften und Einsatzmöglichkeiten erfindungsgemäß herstellbarer Gegenstände können auch durch weitere funktionelle Schichten vorteilhaft erweitert werden. So kann vorteilhaft zumindest eine weitere funktionelle Schicht aufgebracht werden, welche, wenigstens einer der Eigenschaften -elektrisch leitend, -Infrarotreflektierend, -Kratzschutz, -Antireflex, -Versiegelung, -photokatalytisch, -Farbgebend, -antimikrobiell aufweist. Die funktionelle Schicht kann auf der flammpyrolytischen Barriereschicht, oder die flammpyrolytische Barriereschicht auf der weiteren funktionellen Schicht aufgebracht werden.

Ein weiteres vorteilhaftes Beispiel für eine funktionelle Schicht ist eine Indium-Zinn-Oxidschicht. Derartige Schichten werden vielfach als transparente leitfähige Schichten eingesetzt. In Kombination mit einer solchen transparenten leitfähigen Schicht ergibt sich außerdem ein weiterer Vorteil der Erfindung. Indium-Zinn-Oxid (ITO) zeigt schlechte Hafteigenschaften, welche sich sowohl in einer schlechten Haftung des ITO auf dem Substrat, als auch in einer schlechten Haftung von auf einer ITO-Schicht aufgebrachten Schichten äußert. Durch die Eigenschaft der erfindungsgemäßen flammpyrolytischen Schicht, aufgrund der vorhandenen Hydroxylgruppen eine gute Anbindung zu bewirken, kann die flammpyrolytische Barrierebeschichtung gleichzeitig als Haftvermittler für die ITO-Schicht dienen. Wird eine flammpyrolytische Barriereschicht vor der ITO-Schicht auf dem Substrat abgeschieden, so ergibt sich eine verbesserte Haftung des darauf aufgebrachten ITO. Ebenso kann eine bessere Haftung nachfolgender Schichten auf eine mit ITO beschichteten Substrat erreicht werden, wenn vorher eine flammpyrolytische Barriereschicht als Haftvermittler abgeschieden wird.

Eine weitere Ausführungsform der Erfindung sieht vor, daß das Substrat mit einer hydrophoben Beschichung beschichtet wird. Gemäß einer bevorzugten Weiterbildung wird dazu eine Silikat-haltige Schicht mit einer hydrophoben Komponente, insbesondere eine Fluorverbindung, bevorzugt Fluoralkylsilan verwendet. Es hat sich insbesondere auch hier als besonders vorteilhaft erwiesen, wenn die hydrophoben Beschichung auf der flammpyrolytischen Beschichtung aufgebracht wird. Eine derartige Schichtanordnung führt zu besonders beständigen hydrophoben Schichten. Derartige Beschichtungen können beispielsweise leicht reinigbare Oberflächen schaffen und werden außerdem in der am gleichen Tag wie die vorliegende Anmeldung eingereichte PCT-Anmeldung der Anmelderin mit dem Titel "Gegenstand mit leicht reinigbarer Oberfläche und Verfahren zu seiner Erstellung" beschrieben.

Das Aufbringen der hydrophoben Beschichtung umfaßt demgemäß in Weiterbildung auch das Aufbringen eines Silikat-haltigen Sol-Gels auf der flammpyrolytischen Schicht, wobei das Sol-Gel eine hydrophoben Komponente, insbesondere eine Fluorverbindung, bevorzugt Fluoralkylsilan enthält.

Die Erfindung kann zur Herstellung einer Vielzahl von Erzeugnissen verwendet werden, für die Barriere- oder Gleitschichten verbesserte Produkteigenschaften ergeben. Beispielsweise kann ein erfindungsgemäßer Gegenstand
- eine Backofenscheibe, oder
- ein Glaskeramik-Kochfeld sein.

Im folgenden wird die Erfindung anhand von Ausführungsbeispielen und unter Bezugnahme auf die Zeichnungen näher erläutert, wobei gleiche und ähnliche Elemente mit gleichen Bezugszeichen versehen sind und die Merkmale verschiedener Ausführungsbeispiele miteinander kombiniert werden können.

Es zeigen:
- Fig, 1: eine Anordnung und ein Verfahren gemäß eines Ausführungsbeispiels zur Herstellung eines erfindungsgemäßen flammpyrolytisch beschichteten Gegenstands,
- Fig. 2: die Herstellung einer Glaskeramikplatte mit erfindungsgemäßer flammpyrolytischer Beschichtung,
- Fig. 3: eine dekorierte Glaskeramik-Platte mit erfindungsgemäßer flammpyrolytischer Barrierebeschichtung,
- Fig. 4: Ausführungsbeispiele eines erfindungsgemäßen Gegenstands mit Indium-Zinn-Oxidschicht und hydrophober Beschichtung,
- Fig. 5: ein Ausführungsbeispiel mit mehrlagiger flammpyrolytischer Beschichtung,
- Fig. 6: einen Kaminofen mit erfindungsgemäß beschichteter Ofensichtscheibe, und
- Fig. 7 und 8: rasterelektronenmikroskopische Aufnahmen einer flammpyrolytisch abgeschiedenen Barriereschicht.

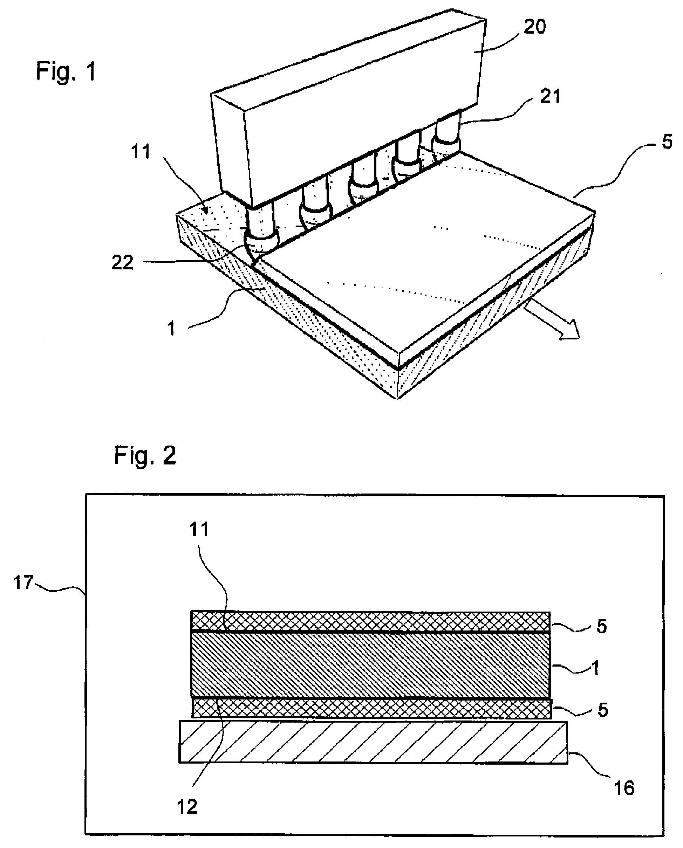

Fig. 1 zeigt eine Anordnung mit welcher gemäß der Erfindung ein Gegenstand mit flammpyrolytischer Barrierebeschichtung herstellbar ist. Die Herstellung erfindungsgemäßer Gegenstände mit einer Barrierebeschichtung auf einem Substrat basiert darauf, daß zumindest ein Bereich der Oberfläche des Substrats mit einer Flamme überstrichen und eine metalloxidhaltige Schicht mittels Hydrolyse einer metallhaltigen Verbindung in der Flamme abgeschieden wird, während die Flamme den Bereich des Substrats überstreicht.

Zur Herstellung des Gegenstands wird ein flaches, scheibenförmiges Glassubstrat bereitgestellt. Als Substrat 1 kann, wie bei dem in Fig. 1 gezeigten Ausführungsbeispiel eine Glasscheibe aus Floatglas, gewalztem oder gezogenem Glas verwendet werden, welche durch Abtrennen eines Abschnitts von einem kontinuierlich hergestellten gefloateten und/oder gewalzten Glasband hergestellt wird.

Zur Abscheidung der flammpyrolytischen, Metalloxid-haltigen Schicht 5 wird die Seite 11 des in diesem Beispiel flachen, scheibenförmigen Substrats 1 dann mit Flammen 22 überstrichen, indem das Substrat 1 an einer Brennerbatterie 20 mit Brennern 21, welche die Flammen 22 erzeugen, vorbeigeführt wird. Selbstverständlich ist es auch möglich, anstelle oder zusätzlich zur Bewegung des Substrats 1 die Brennerbatterie 20 zu bewegen.

Das Metalloxid der flammpyrolytischen Schicht 5 kann insbesondere Siliziumoxid, beziehungsweise Silikat sein oder Silikat, beziehungsweise Siliziumoxid umfassen. Dazu wird den Flammen eine Siliziumverbindung zugeführt. Bevorzugt erfolgt die Zuführung durch Beimischung einer gasförmigen oder verdampfbaren Siliziumverbindung zum Brenngas. Als Brenngas wird bevorzugt ein Gas mit einer oder mehreren der Komponenten Wasserstoff, Methan, Propan, Butan eingesetzt. Die Verbrennung erfolgt an Luft. Alternativ oder zusätzlich kann auch Sauerstoff zugeführt werden.

Durch die Hydrolyse der Siliziumverbindung in den Flammen 21 wird auf dem Substrat 1 dann eine flammpyrolytische silikathaltige Schicht 5 abgeschieden. Als Siliziumverbindung kann insbesondere Hexamethyldisiloxan (HMDSO), Hexamethyldisilazan (HMDSN) und/oder Tetraethoxysilan der Flamme zugeführt werden. Bevorzugt werden Silane, wie Tetraethoxysilan eingesetzt.

Alternativ oder zusätzlich -je nachdem, welche funktionellen Eigenschaften die Schicht 5 erhalten soll, können auch eine oder mehrere Verbindungen mit den Metallen Titan, Aluminium, Zirkonium, Zinn, Indium den Flammen 22 zugesetzt werden, um durch Hydrolyse dieser Verbindungen Metalloxide dieser Metalle zu erhalten. Auch können auf diese Weise Mischoxide abgeschieden werden, wie etwa silikathaltige Schichten, welche mit einem oder mehreren Oxiden der Metalle Titan, Aluminium, Zirkonium, Zinn, Indium dotiert sind.

Die Beschichtung mit verschiedenen Oxiden kann auch sequentiell erfolgen. Dazu kann das Substrat 1 mehrmals mit den Flammen 22 der Brennerbatterie 20 überstrichen werden, wobei jeweils andere metallhaltige Verbindungen zugesetzt und hydrolysiert werden. Auch können dazu mehrere Brennerbatterien hintereinander angeordnet werden, wobei in den jeweiligen Brennern der Brennerbatterien verschiedene Metalloxide hydrolysiert werden.

Es hat sich als bei der Beschichtung außerdem als vorteilhaft erwiesen, Flammen mit einem oxidierenden und einem reduzierenden Teil zu erzeugen und das Substrat nur mit dem oxidierenden Teil zu überstreichen. Damit wird eine möglichst vollständige Hydrolyse erreicht und die Einlagerung unvollständig verbrannter Brenngasbestandteile, wie beispielsweise von Kohlenwasserstoffen vermieden. Auch können dem Brenngas zur Unterstützung der Hydrolyse reduzierende Komponenten, wie Wasserstoff oder Kohlenmonoxid beigemischt werden.

Die für die Schichtdicke der Schicht 5 relevanten Beschichtungsparameter, wie unter anderem die Zusammensetzung des Brenngases mit Siliziumverbindung und die Geschwindigkeit des Vorbeiführens des Substrats 1 an den Flammen 22 werden so eingestellt, daß die flammpyrolytische Schicht 5 eine Schichtdicke von 1 bis 100 Nanometern, bevorzugt 4 bis 40 Nanometern, besonders bevorzugt höchstens 20 Nanometern aufweist. Selbst mit Schichtdicken unter 20 Nanometern kann in vielen Fällen noch eine ausreichende Barrierewirkung der Schicht 5 erzielt werden.

Die erfindungsgemäße flammpyrolytzsche Schicht 5 kann außerdem die Stoßfestigkeit verbessern. Wird die Schicht 5 erfindungsgemäß vor dem Keramisieren des Ausgangsglases aufgebracht, so kann ein Ankleben der Glasplatte beim Keramisieren auf der Keramisierungsunterlage vermieden werden. Damit werden auch Kratzer, die durch ein Ankleben, Schrumpfen und dadurch verursachten Ablösen der beim Keramisieren sehr weichen Platte von der Unterlage entstehen, vermieden. Da diese Kratzer die Stoßfestigkeit der fertig keramisierten Platte herabsetzen, kann eine verbesserte Festigkeit erzielt werden.

Fig. 2 zeigt dazu das Herstellen einer Glaskeramikplatte gemäß einer Ausführungsform der Erfindung. Erfindungsgemäß wird dabei die metalloxidhaltige Schicht vor dem Keramisieren auf zumindest einer Seite 11, 12 eines Ausgangsglassubstrats 1 aufgebracht. Bei dem in Fig. 2 dargestellten Ausführungsbeispiel wurde das Ausgangsglassubstrat 1 beidseitig auf den Seiten 11, 12 beschichtet. Anschließend wird das Ausgangsglassubstrat 1 mit der beschichteten Seite 12 auf eine Keramisierungsunterlage 16 aufgelegt und dann in einem Keramisierungsofen 17 keramisiert. Da ein Anhaften des Substrats 1 an der Unterlage 16 vermieden wird, ist es auch nicht mehr notwendig, ein auf der Auflageseite -im dargestellten Ausführungsbeispiel die Seite 12- genopptes Substrat 1 zu verwenden. Vielmehr erlaubt es die Erfindung in vorteilhafter Weise, ein nicht genopptes, also beidseitig glattes Ausgangsglassubstrat 1 zu verwenden und damit beidseitig glatte Glaskeramik-Platten ohne eine wesentliche Beeinträchtigung der Festigkeit herzustellen.

Wird, wie bei dem in Fig. 2 gezeigten Substrat 1 auch die der Seite 11 gegenüberliegende Seite 12 mit einer flammpyrolytischen Schicht 5 beschichtet, ergeben sich außerdem noch weitere Vorzüge der Erfindung. Ist die Unterseite der Glaskeramik-Platte mit einer erfindungsgemäßen flammpyrolytischen Schicht versehen, so kann diese vorteilhaft auch die Glaskeramik vor der Eindiffusion aggressiver Verbrennungsrückstände und einer damit verbundenen langfristigen Schädigung der Platte schützen, wie sie bei gasbeheizten Glaskeramik-Kochfeldern auftreten.

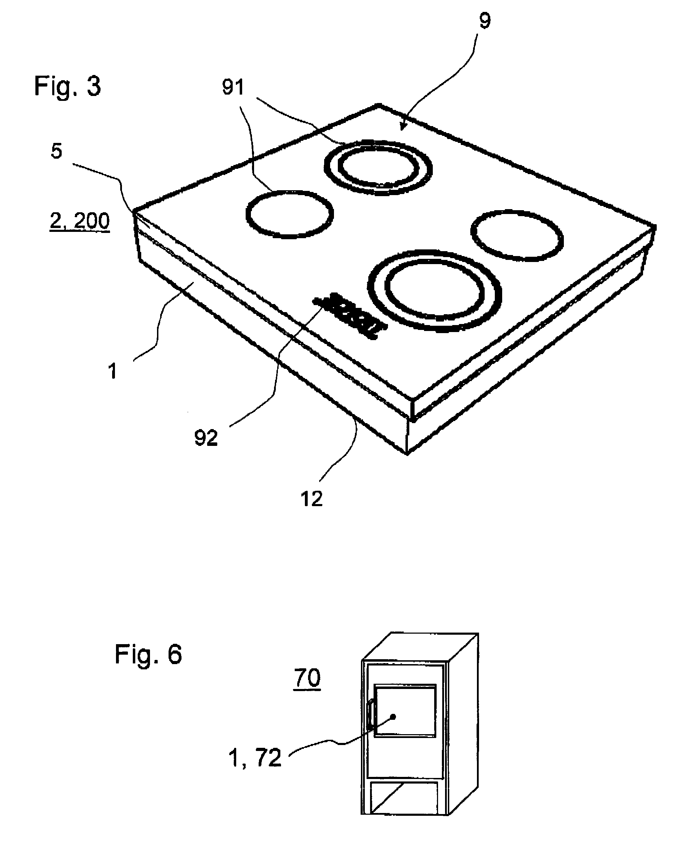

Fig. 3 zeigt eine Anwendung für ein derartiges mit einer flammpyrolytischen Barrierebeschichtung versehenes Substrat. Bei dem in Fig. 3 dargestellten Gegenstand 2 handelt es sich um eine Glaskeramikplatte, wie insbesondere ein Kochfeld 200 mit einem Dekor 9.

Zur Herstellung eines solchen Erzeugnisses wird keramische Dekorfarbe strukturiert auf ein flammpyrolytisch beschichtetes Glassubstrat 1 aufgetragen, wobei die Beschichtung mit der flammpyroytischen Schicht 5 wie anhand von Fig. 1 erläutert erfolgt. Das Dekormuster umfaßt in diesem Beispiel Muster in Form von kreisförmige Kochfeldbegrenzungen 91 und einem Herstellerlogo 92. Der Auftrag der Dekorfarbe 9 mit den Mustern 91, 92 auf die Schicht 5 kann beispielsweise durch Siebdruck erfolgen.

Anschließend wird das Substrat 1 keramisiert, wobei gleichzeitig durch das Keramisieren der Einbrand der Dekorfarbe erfolgt. Es hat sich beim Einbrennen des Dekors gezeigt, daß eine Diffusion von Komponenten der Dekorfarbe und/oder Komponenten des Glassubstrats zu einer unschönen Hof-oder Saumbildung entlang der Ränder der Dekorstrukturen 91, 92 führt. In höchst überraschend einfacher Weise kann hier eine kostengünstig aufzubringende flammpyrolytische Barrierebeschichtung die Diffusion unterdrücken und damit die unerwünschte Hofbildung vermeiden. Aufgrund der in der Schicht 5 und an deren Oberfläche vorhandenen Hydroxylgruppen wird zudem eine bessere Haftung und damit erhöhte Haltbarkeit des Dekors 9 erreicht.

Durch die flammpyrolytische Schicht 5 wird außerdem eine glattere Oberfläche der Glaskeramikplatte erzielt und in der Platte vorhandene Poren, insbesondere bis zu einer Porengröße von 5 Nanometern geschlossen. Dies verhindert auch bei der Verwendung langfristig ein Eindringen von Rückständen, etwa durch eingebrannte Speisereste.

Weitere Anwendungen einer flammpyrolytischen Sperr- oder Barriereschicht auf Glas sind beispielsweise Backofenscheiben. Auf Pharmabehältern erlaubt die flammpyrolytische Beschichtung auch die Verwendung von Glassorten, bei welchen es ansonsten zu einem Austritt von Glasbestandteilen, wie insbesondere von Alkaliionen und dadurch einer Verunreinigung der verpackten Medikamente kommen kann.

Dem Brenngas kann auch eine metallhaltige Verbindung, beispielsweise eine metallorganische Verbindung zugesetzt werden, welches durch Hydrolyse ein leitendes oder halbleitendes Oxid ergibt. Damit kann dann unter anderem auch eine flammpyrolytische Barrierebeschichtung 5 abgeschieden werden, die ein leitendes oder halbleitendes Oxid enthält. Auf diese Weise können der Schicht 5 zusätzlich antistatische Eigenschaften verliehen werden. Um eine solche Schicht herzustellen, kann der Flamme beispielsweise als Zusatz zu einer Siliziumverbindung eine Zinnverbindung zugeführt werden, so daß die flammpyrolytische Schicht neben Siliziumoxid auch Zinnoxid enthält.

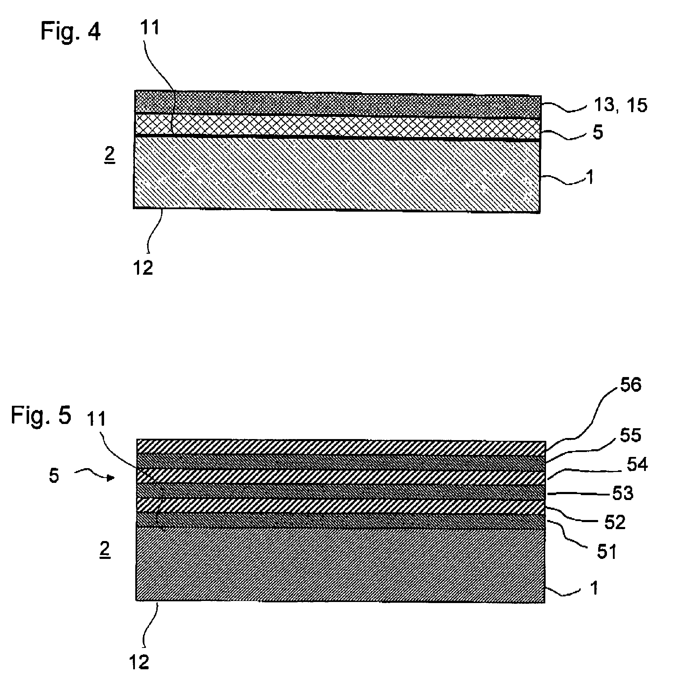

Anhand von Fig. 4 werden zwei weitere Ausführungsbeispiele erfindungsgemäß hergestellter Gegenstände 2 erläutert. Bei beiden Ausführungsbeispielen ist zunächst auf einer Seite 11 eines Substrats 1 eine silikathaltige flammpyrolytische Barriereschicht 5 durch Beflammung der Seite 11 mit einer oder mehreren Flammen und Hydrolyse einer Siliziumverbindung, vorzugsweise eines Silans in der Flamme abgeschieden worden.

Gemäß einem ersten Ausführungsbeispiel ist auf dieser Schicht 5 eine Indium-Zinn-Oxidschicht 13 abgeschieden worden. Das Abscheiden dieser Schicht 13 kann beispielsweise durch Sputtern erfolgen. Neben einer Barrierewirkung aufgrund der dichten Struktur der Schicht 5 wird außerdem eine Verbesserung der Hafteigenschaften der ITO-Schicht 13 erzielt, da die Schicht 5 an ihrer Oberfläche Hydroxylgruppen aufweist, mit welchen eine gute Bindung an das ITO erreicht wird.
Es ist außerdem daran gedacht, auch die Indium-Zinn-Oxidschicht 13 flammpyrolytisch abzuscheiden.
Dazu kann die Seite 11 des Substrats 1 sequentiell mit Flammen überstrichen werden, wobei die silikathaltige Schicht 5 durch Zusatz einer Siliziumverbindung, beispielsweise ein Silan, zur Flamme zugesetzt und dann durch Überstreichen mit einer oder mehreren weiteren Flammen, denen Indium- und Zinnverbindungen zugesetzt werden, die Indium-Zinn-Oxidschicht 13 abgeschieden wird. Auf diese Weise wird dementsprechend eine mehrlagige flammpyrolytische Beschichtung erhalten. Eine Alternative zu einer derartigen Schicht 13 ist eine Fluor-dotierte Zinnoxidschicht, die ebenfalls flammpyrolytisch durch Hydrolyse von Zinn- und Fluorverbindungen herstellbar ist. Gemäß einem weiteren Ausführungsbeispiel wird auf der flammpyrolytischen Schicht 5 eine hydrophobe Beschichtung aufgebracht. Dazu wird bei dem in Fig. 4 dargestellten Ausführungsbeispiel ein Silikat-haltiges Sol-Gel mit einer hydrophoben Komponente aufgebracht, welches dann eine hydrophobe Schicht 15 bildet. Bevorzugt wird als hydrophobe Komponente ein Fluoralkylsilan verwendet, welches dem Sol-Gel beigemischt wird. Neben der Barrierewirkung wird außerdem durch die flammpyrolytische Schicht 5 eine vorzügliche Haftungsverbesserung der hydrophoben Sol-Gel-Schicht bewirkt, so daß diese Schichten besonders haltbar sind. Geeignet ist ein derartiges Schichtsystem beispielsweise, um einem erfindungsgemäßen Gegenstand schmutzabweisende Eigenschaften und damit eine leichte Reinigbarkeit zu verleihen.

Anstelle oder zusätzlich zur hydrophoben Schicht 15 und/oder der ITO-Schicht 13 können auch andere funktionelle Schichten aufgebracht werden. Beispielsweise kann eine infrarotreflektierende Zinnoxidschicht, oder eine harte Kratzschutzschicht, Interferenzschichten, wie beispielsweise eine Antireflexbeschichtung, eine Verspiegelungsschicht, eine photokatalytisch wirksame Schicht -beispielsweise eine Titanoxid-haltige Schicht und/oder eine farbgebende Schicht aufgebracht werden.

Fig. 5 zeigt ein weiteres Ausführungsbeispiel mit mehrlagiger flammpyrolytischer Schicht 5. Bei diesem Ausführungsbeispiel ist eine flammpyrolytische Schicht 5 mit Lagen 51 - 56 durch sequentielles Überstreichen mit Flammen abgeschieden worden, denen abwechselnd verschiedene metallhaltige Verbindungen zugesetzt wurden. Die so erzeugte Wechselschicht kann unter anderem als Interferenz-Schichtsystem wirken und auf diese Weise verspiegelnd, entspiegelnd und/oder farbgebend wirken. Beispielsweise können dazu sequentiell silikathaltige Lagen und Titanoxidhaltige Lagen durch Zusatz von Silan und Titanchlorid flammpyrolytisch hergestellt werden.

Fig. 6 zeigt ein weiteres Beispiel eines Produkts mit einem erfindungsgemäß beschichteten Substrat. Ein Kaminofen 70 weist ein Glaskeramik-Substrat 1 als Kaminsichtscheibe 72 auf. Die Innenseite des Substrats 1, beziehungsweise der Kaminsichtscheibe 72 ist dabei erfindungsgemäß wie beispielsweise anhand von Fig. 1 dargestellt, mit einer flammpyrolytischen Siliziumoxid-haltigen Schicht 5 durch Überstreichen mit einer Flamme, der eine Siliziumverbindung zugeführt wird, beschichtet. Die Siliziumoxid-haltige Schicht 5 dient hier als Diffusionsbarriere oder Sperrschicht, um das Eindringen von im Innenraum entstehenden Verbrennungsprodukten in die Kaminsichtscheibe 72 zu verhindern oder zumindest zu verlangsamen. Insbesondere bei der Verbrennung von schwefelhaltigen Verbrennungsprodukten -Holz oder fossile Brennstoffe, wie Erdgas oder Erdöl- kommt es zur Bildung von Schwefeloxiden, welche die Glaskeramik der Sichtscheibe 72 korrodieren können.

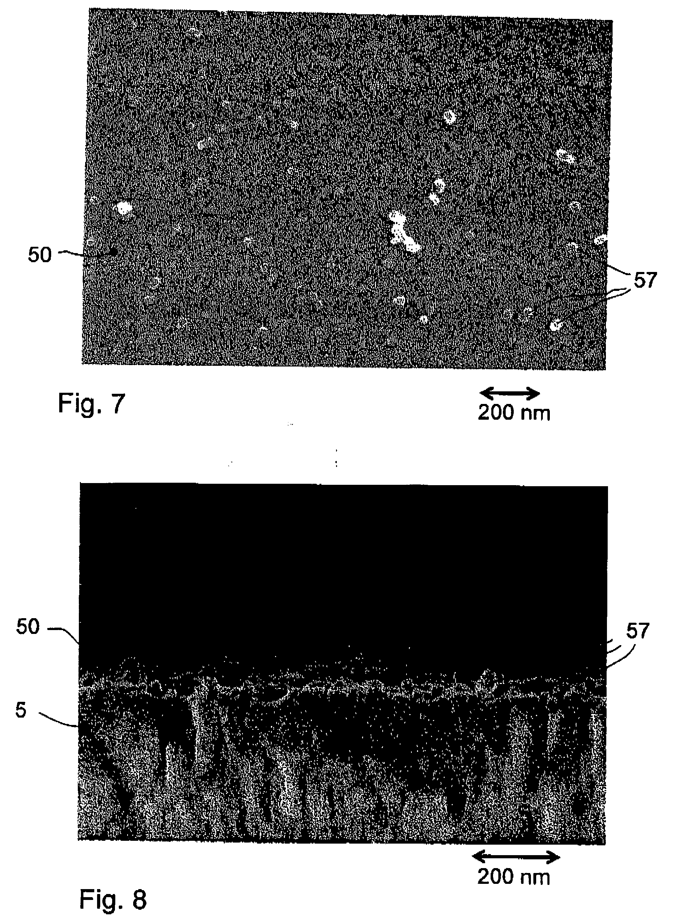

In den Fig. 7 und 8 sind rastelelektronische Aufnahmen von einem mit einer flammpyrolytisch abgeschiedenen Schicht beschichteten Glaskeramik-Substrat dargestellt. Dabei zeigt Fig. 11 die beschichtete Oberfläche in Aufsicht und Fig. 12 eine Aufnahme einer Bruchkante des beschichteten Substrats. Die Vergrößerung dieser Aufnahmen ist anhand der unter den Bildern gezeigten Maßstabsbalken zu entnehmen. Die in Fig. 8 gezeigte Aufsicht auf die Oberfläche der flammpyrolytischen Schicht wurde mit einer Beschleunigungsspannung von 5 kV mit 200000-facher Vergrößerung aufgenommen. Das in Fig. 9 gezeigte Bild wurde mit 300000-facher Vergrößerung ebenfalls mit einer Beschleunigungsspannung von 5 kV aufgenommen.

Beide Bilder zeigen, daß die Oberfläche 50 der flammpyrolytischen Schicht 5 insgesamt eine körnige Struktur mit Siliziumoxid-haltigen Körnern 57 aufweist. Von den in den Aufnahmen erkennbaren Körnern weisen mehr als 90 % einen Durchmesser kleiner als 80 Nanometer, sogar kleiner als 60 Mikrometer, überwiegend bis 40 Nanometer auf. Aufgrund dieser feinkörnigen Schichtstruktur wird eine besonders große Oberfläche mit optisch aufgrund der geringen Größe der Körner nicht auffälliger Struktur erzielt. Die große Oberfläche in Verbindung mit den an der Oberfläche der Siliziumoxid-haltigen Schicht 5 zumindest in frisch abgeschiedenem Zustand in hoher Dichte vorhandenen OH-Gruppen sorgt für eine besonders gute Haftung nachfolgend aufgebrachter Materialien, wie etwa weiteren Schichten.

Es ist dem Fachmann ersichtlich, dass die Erfindung nicht auf die vorstehend beschriebenen Ausführungsformen beschränkt ist, sondern vielmehr in vielfältiger Weise variiert werden kann. Insbesondere können die Merkmale der einzelnen beispielhaften Ausführungsformen auch miteinander kombiniert werden.

## Patentansprüche

1. Verfahren zur Herstellung eines Glaskeramik-Gegenstands (2) mit einer Barrierebeschichtung auf einem Substrat (1), , bei welchem zumindest ein Bereich der Oberfläche des Substrats (1) mit einer Flamme überstrichen und eine metalloxidhaltige oder silikathaltige Schicht (5) mittels Hydrolyse einer metallhaltigen Verbindung oder einer Siliziumverbindung in der Flamme (22) abgeschieden wird, während die Flamme (22) den Bereich des Substrats (1) überstreicht, **dadurch gekennzeichnet, daß** die metalloxidhaltige oder silikathaltige Schicht (5) vor dem Keramisieren auf zumindest eine Seite (11, 12) eines Ausgangsglassubstrats (1) aufgebracht, das Ausgangsglassubstrat (1) mit dessen beschichteter Seite auf eine Keramisierungsunterlage (16) aufgelegt und dann keramisiert wird.

2. Verfahren gemäß Anspruch 1, **dadurch gekennzeichnet, daß** als Siliziumverbindung zumindest eine der Substanzen
- Hexamethyldisiloxan (HMDSO),
- Hexamethyldisilazan (HMDSN),
- Tetramethoxysilan,
- Tetraethoxysilan
verwendet wird.

3. Verfahren gemäß einem der vorstehenden Ansprüche, **dadurch gekennzeichnet, daß** in der Flamme (22) eine Verbindung eines der Metalle Titan, Aluminium, Zirkonium, Zinn, Indium hydrolysiert wird.

4. Verfahren gemäß einem der vorstehenden Ansprüche, **dadurch gekennzeichnet, daß** das Substrat (1) mit einer Flamme (22) überstrichen und eine metalloxidhaltige oder silikathaltige Schicht (5) mittels Hydrolyse mehrerer metallhaltiger Verbindung in der Flamme (22) abgeschieden wird.

5. Verfahren gemäß einem der vorstehenden Ansprüche, **dadurch gekennzeichnet, daß** die Oberfläche sequentiell mit einer oder mehreren Flammen (22) überstrichen wird, welcher oder welchen jeweils unterschiedliche metall-oder siliziumhaltige Verbindungen zugeführt werden.

6. Verfahren gemäß einem der vorstehenden Ansprüche, bei welchem eine Flamme (22) mit einem oxidierenden und einem reduzierenden Teil erzeugt und das Substrat (1) nur mit dem oxidierenden Teil überstrichen wird.

7. Verfahren gemäß einem der vorstehenden Ansprüche, **dadurch gekennzeichnet, daß** die flammpyrolytische Schicht (5) mit einer Schichtdicke von 1 bis 100 Nanometern, bevorzugt 4 bis 40 Nanometern, besonders bevorzugt höchstens 20 Nanometern abgeschieden wird.

8. Verfahren gemäß einem der vorstehenden Ansprüche, **dadurch gekennzeichnet, daß** ein Methan, Propan- oder Butan enthaltendes Brenngas zur Erzeugung der Flamme (22) verwendet wird.

9. Verfahren gemäß einem der vorstehenden Ansprüche, **dadurch gekennzeichnet, daß** ein eine reduzierende Komponente, vorzugsweise Wasserstoff oder Kohlenmonoxid enthaltendes Brenngas zur Erzeugung der Flamme (22) verwendet wird.

10. Verfahren gemäß einem der vorstehenden Ansprüche, **dadurch gekennzeichnet, daß** auf der metalloxidhaltigen Schicht (5) keramische Dekorfarbe (9) aufgebracht und eingebrannt wird.

11. Verfahren gemäß einem der vorstehenden Ansprüche, **dadurch gekennzeichnet, daß** dem Brenngas eine metallorganische Verbindung zugesetzt wird, welches durch Hydrolyse ein leitendes oder halbleitendes Oxid ergibt.

12. Verfahren gemäß einem der vorstehenden Ansprüche, **dadurch gekennzeichnet, daß** auf der flammpyrolytischen Schicht (5) eine hydrophobe Beschichtung (15) aufgebracht wird.

13. Verfahren gemäß Anspruch 12, **dadurch gekennzeichnet, daß** auf der flammpyrolytischen Schicht (5) eine Silikat-haltiges Sol-Gel mit einer hydrophoben Komponente, insbesondere eine Fluorverbindung, bevorzugt Fluoralkylsilan aufgebracht wird.

14. Verfahren gemäß einem der vorstehenden Ansprüche, **dadurch gekennzeichnet, daß** mit der flammpyrolytischen Abscheidung eine körnige Oberflächenstruktur der vorzugsweise Siliziumoxid-haltigen flammpyrolytischen Schicht (5) mit auf der Oberfläche der Schicht angeordneten Körnern (57) mit einem Durchmesser bis 80 Nanometer, vorzugsweise bis 60 Nanometer erzeugt wird.

## Claims

1. Method of producing a glass-ceramic article (2) having a barrier coating on a substrate (1), in which a flame is passed over at least a region of the surface of the substrate (1) and a metal oxide-containing or silicate-containing layer (5) is deposited in the flame (22) by means of hydrolysis of a metal-containing compound or a silicon compound, while the flame (22) passes over the region of the substrate (1), **characterised in that** the metal oxide-containing or silicate-containing layer (5) is applied to at least one side (11, 12) of an initial glass substrate (1) prior to ceramization, the initial glass substrate (1) is placed with its coated side onto a ceramization base (16) and is then ceramized.

2. Method as claimed in claim 1, **characterised in that** the silicon compound used is at least one of the following substances
- hexamethyldisiloxane (HMDSO),
- hexamethyldisilazane (HMDSN),
- tetramethoxysilane,
- tetraethoxysilane.

3. Method as claimed in any one of the preceding claims, **characterised in that** a compound of one of the metals titanium, aluminium, zirconium, tin, indium is hydrolysed in the flame (22).

4. Method as claimed in any one of the preceding claims, **characterised in that** a flame (22) is passed over the substrate (1) and a metal oxide-containing or silicate-containing layer (5) is deposited in the flame (22) by means of hydrolysis of a plurality of metal-containing compound[s].

5. Method as claimed in any one of the preceding claims, **characterised in that** the surface is passed over sequentially by one or a plurality of flames (22) which is/are supplied in each case with different metal-containing or silicon-containing compounds.

6. Method as claimed in any one of the preceding claims, in which a flame (22) is produced having an oxidising part and a reducing part and only the oxidising part passes over the substrate (1).

7. Method as claimed in any one of the preceding claims, **characterised in that** the flame-pyrolytic layer (5) is deposited having a layer thickness of 1 to 100 nanometres, preferably 4 to 40 nanometres, particularly preferably no more than 20 nanometres.

8. Method as claimed in any one of the preceding claims, **characterised in that** a combustible gas containing methane, propane or butane is used for production of the flame (22).

9. Method as claimed in any one of the preceding claims, **characterised in that** a combustible gas containing a reducing component, preferably hydrogen or carbon monoxide, is used for production of the flame (22).

10. Method as claimed in any one of the preceding claims, **characterised in that** ceramic decorative paint (9) is applied on the metal oxide-containing layer (5) and fired in.

11. Method as claimed in any one of the preceding claims, **characterised in that** an organometallic compound is added to the combustible gas which produces a conducting or semiconducting oxide by means of hydrolysis.

12. Method as claimed in any one of the preceding claims, **characterised in that** a hydrophobic coating (15) is applied on the flame-pyrolytic layer (5).

13. Method as claimed in claim 12, **characterised in that** a silicate-containing sol gel having a hydrophobic component, in particular a fluorine compound, preferably fluoralkylsilane, is applied on the flame-pyrolytic layer (5).

14. Method as claimed in any one of the preceding claims, **characterised in that** a granular surface structure of the flame-pyrolytic layer (5), which preferably contains silicon oxide and has grains (57) disposed on the surface of the layer with a diameter of up to 80 nanometres, preferably up to 60 nanometres, is produced by the flame-pyrolytic deposition.

## Revendications

1. Procédé de fabrication d'un article de vitrocéramique (2) comportant un revêtement barrière sur un substrat (1), dans lequel au moins une zone de la surface du substrat (1) est passée à la flamme et une couche (5) contenant un oxyde de métal ou contenant un silicate est déposée par hydrolyse sur un composé contenant du métal ou un composé de silicium dans la flamme (22), pendant le passage de la zone du substrat (1) à la flamme (22), **caractérisé en ce que** la couche (5) contenant un oxyde de métal ou un silicate est appliquée avant la céramisation sur au moins un côté (11, 12) d'un substrat en verre de départ (1), le substrat en verre de départ (1) avec son côté revêtu est déposé sur un support de céramisation (16) et est ensuite céramisé.

2. Procédé selon la revendication 1, **caractérisé en ce que**, en tant que composé de silicium, au moins une des substances consistant en :
- hexaméthyldisiloxane (HMDSO),
- hexaméthyldisilazane (HMDSN),
- tétraméthoxysilane,
- tétraéthoxysilane,
est utilisée.

3. Procédé selon l'une des revendications précédentes, **caractérisé en ce que**, dans la flamme (22), un composé d'un des métaux titane, aluminium, zirconium, étain, indium est hydrolysé.

4. Procédé selon l'une des revendications précédentes, **caractérisé en ce que** le substrat (1) est passé à la flamme (22) et une couche (5) contenant un oxyde de métal ou contenant un silicate est déposée par hydrolyse de plusieurs composés contenant du métal dans la flamme (22).

5. Procédé selon l'une des revendications précédentes, **caractérisé en ce qu'**une ou plusieurs flammes (22) sont passées de manière séquentielle sur la surface, à laquelle ou auxquelles sont à chaque fois amenés différents composés contenant du métal ou du silicium.

6. Procédé selon l'une des revendications précédentes, dans lequel une flamme (22) est générée avec un élément oxydant et un élément réducteur et le substrat (1) n'est passé à la flamme qu'avec l'élément oxydant.

7. Procédé selon l'une des revendications précédentes, **caractérisé en ce que** la couche (5) appliquée par pyrolyse à la flamme est déposée avec une épaisseur de couche de 1 à 100 nanomètres, de préférence de 4 à 40 nanomètres, plus préférablement de 20 nanomètres tout au plus.

8. Procédé selon l'une des revendications précédentes, **caractérisé en ce qu'**un gaz de combustion contenant du méthane, du propane ou du butane est utilisé pour générer la flamme (22).

9. Procédé selon l'une des revendications précédentes, **caractérisé en ce qu'**un gaz de combustion contenant un composant réducteur, de préférence de l'hydrogène ou du monoxyde de carbone, est utilisé pour générer la flamme (22).

10. Procédé selon l'une des revendications précédentes, **caractérisé en ce que**, sur la couche (5) contenant un oxyde de métal, une peinture décorative céramique (9) est appliquée et cuite.

11. Procédé selon l'une des revendications précédentes, **caractérisé en ce qu'**un composé organométallique est ajouté au gaz de combustion, lequel génère par hydrolyse un oxyde conducteur ou semi-conducteur.

12. Procédé selon l'une des revendications précédentes, **caractérisé en ce que**, sur la couche (5) appliquée par pyrolyse à la flamme, est appliqué un revêtement hydrophobe (15).

13. Procédé selon la revendication 12, **caractérisé en ce que**, sur la couche (5) appliquée par pyrolyse à la flamme, est appliqué un sol-gel contenant un silicate avec un composant hydrophobe, en particulier un composé de fluor, de préférence un fluoroalkylsilane.

14. Procédé selon l'une des revendications précédentes, **caractérisé en ce qu'**avec le dépôt par pyrolyse à la flamme est générée une structure de surface granuleuse de la couche (5) appliquée par pyrolyse à la flamme contenant de préférence un oxyde de silicium avec des grains (57) disposés à la surface de la couche avec un diamètre allant jusqu'à 80 nanomètres, de préférence jusqu'à 60 nanomètres.
